# EUROPEAN PATENT APPLICATION

(11) **EP 4 239 809 A2**
(43) Date of publication of application: **06.09.2023**
(21) Application number: 23183247.8
(22) Date of filing: 11.12.2019
(51) Int. Cl.: H01R 13/52, H05K 5/06, H02B 1/00, H01R 13/506, H01R 13/74, H01R 24/60

(54) **ELECTRIC APPARATUS WITH ELECTRIC CONNECTION AND PROTECTION FUNCTION, CONNECTOR AND FABRICATING METHOD THEREOF**

(30) Priority: 09.01.2019 CN 201910019863
(62) Divisional of application: 19215290.8
(71) Applicant: DELTA ELECTRONICS (SHANGHAI) CO., LTD, Shanghai 201209 (CN)
(72) Inventor: Chen, Jianhong, Shanghai, 201209 (CN); You, Peiai, Shanghai, 201209 (CN); Sun, Hao, Shanghai, 201209 (CN)
(74) Representative: Uexküll & Stolberg

(57) **Abstract**

An electric apparatus (1, 1a) includes a casing (11), a first connector (12) and an electronic component (14). The first connector (12) is partially embedded in an opening (114) of the casing (11) and fixed on the casing (11). The first connector (12) includes a first connection body (121), at least one first wire (122), a protection device (123) and at least one first pin. A first end of the first wire (122) is connected with the corresponding first pin and the first wire (122) is routed from a first end (121a) of the first connection body (121). The protection device (123) is disposed on the first end (121a) of the first connection body (121). The first end (121a) of the first connection body (121) and a portion of the at least one first wire (122) are sealed and covered by the protection device (123). The electronic component (14) is disposed within the casing (11) and electrically connected with a second end of the first wire (122).

## Description

### FIELD OF THE INVENTION

The present disclosure relates to an electric apparatus, a connector of the electric apparatus and a fabricating method of the connector, and more particularly to an electric apparatus with an electric connection and protection function, a connector of the electric apparatus and a fabricating method of the connector.

### BACKGROUND OF THE INVENTION

Nowadays, the assembled structure of an insertion element and a docking element is widely used for transferring electric power or signals between an electric apparatus and an electronic system. For example, the electric apparatus comprises an insertion element and a docking element. The insertion element is located at a lateral side of the electric apparatus. The docking element is electrically connected with the electronic system. The wires of the insertion element are outputted from a wire-outlet end thereof. Moreover, the wires are electrically connected with an electronic component within the casing of the electric apparatus. Since the insertion element has wire-outlet holes and there are vacant spaces between the wires and the inner walls of the wire-outlet holes, some drawbacks occur. When the electric apparatus is applied to a specific environment such as an outdoor low-temperature environment or a high humidity environment, the operation of the electric apparatus may result in moisture because of the high temperature of the electric apparatus and the low temperature of the environment. If the moisture enters the insertion element through the vacant spaces between the wire-outlet ends and the wires, the junction between the internal pins of the insertion element and the wires is readily suffered from a rusting problem or a short-circuited problem. Since the connecting condition and the operating condition are not stable, the conventional electric apparatus is easily damaged.

### SUMMARY OF THE INVENTION

The present disclosure provides an electric apparatus with an electric connection and protection function and a connector of the electric apparatus. The electric apparatus comprises a wall-mount connector. The vacant spaces between the wire-outlet holes of the connector and the wires are sealed. Since the inside and outside of the wall-mount connector are isolated, the waterproof, temperature-resistant and heat-insulation functions can be achieved. Since the junction between the internal pins of the insertion element and the wires is not suffered from a rusting problem or a short-circuited problem, the connecting condition and the operating condition of the electric apparatus are more stable. In such way, the electric apparatus can be applied to the specific environment such as an outdoor low-temperature environment or a high humidity environment.

The present disclosure provides a method of fabricating the connector in the cost-effective, simplified and mass-production manners.

In accordance with an aspect of the present disclosure, an electric apparatus with an electric connection and protection function is provided. The electric apparatus includes a casing, a first connector and at least one electronic component. The casing includes at least one first opening. The first connector is partially embedded in the first opening and fixed on the casing. The first connector includes a first connection body, at least one first wire, a protection device and at least one first pin. The first connection body has a first end and a second end. The at least one first pin is disposed within the first connection body. A first end of the first wire is connected with the corresponding first pin and the first wire is routed from the first end of the first connection body. The protection device is disposed on the first end of the first connection body. The first end of the first connection body and a portion of the at least one first wire are sealed and covered by the protection device. The at least one electronic component is disposed within the casing and electrically connected with a second end of the at least one first wire.

In accordance with another aspect of the present disclosure, a connector is provided. The connector includes a connection body, at least one pin, at least one wire and a protection device. The connection body has a first end and a second end. The at least one pin is disposed within the connection body. A first end of the wire is connected with the corresponding pin and the wire is routed from the first end of the connection body. The protection device is disposed on the first end of the connection body. The first end of the connection body and a portion of the at least one wire are sealed and covered by the protection device.

In accordance with another aspect of the present disclosure, a method of fabricating a connector is provided. Firstly, an assembly of a connection body and at least one wire is provided. The connection body has a first end and a second end, and the at least one wire is routed from the first end of the connection body. Then, a protective stopper is formed on the first end of the connection body. Then, a potting wall is formed on the first end of the connection body. The potting wall is connected with and protruded externally from the first end of the connection body to enclose the first end of the connection body, so that the protective stopper is disposed within the potting wall. Then, a protective sealant is filled within the potting wall.

In accordance with another aspect of the present disclosure, a method of fabricating a connector is provided. Firstly, an assembly of a connection body and at least one wire is provided. The connection body includes a first end and a second end, and the at least one wire is routed from the first end of the connection body. Then, a potting wall is formed on the first end of the connection body. Then, a protective stopper is disposed within the potting wall. Then, a protective cap is coupled with the connection body.

The above contents of the present disclosure will become more readily apparent to those ordinarily skilled in the art after reviewing the following detailed description and accompanying drawings, in which:

### BRIEF DESCRIPTION OF THE DRAWINGS

FIG. 1 is a schematic view illustrating an electric apparatus with an electric connection and protection function according to a first embodiment of the present disclosure;
FIGS. 2A to 2D schematically illustrate a process of fabricating a first connector of the electric apparatus as shown in FIG. 1;
FIG. 3 is a schematic view illustrating an electric apparatus with an electric connection and protection function according to a second embodiment of the present disclosure;
FIG. 4A is a schematic perspective view illustrating the first connector of the electric apparatus as shown in FIG. 3;
FIG. 4B is a schematic exploded view illustrating the first connector as shown in FIG. 4A and taken along another viewpoint;
FIG. 5 is a flowchart illustrating a method of fabricating the first connector of the electric apparatus as shown in FIG. 1;
FIG. 6 is a flowchart illustrating a method of fabricating the first connector of the electric apparatus as shown in FIG. 3; and
FIG. 7 is a flowchart illustrating a method of fabricating the first connector of the electric apparatus as shown in FIG. 3 according to another embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

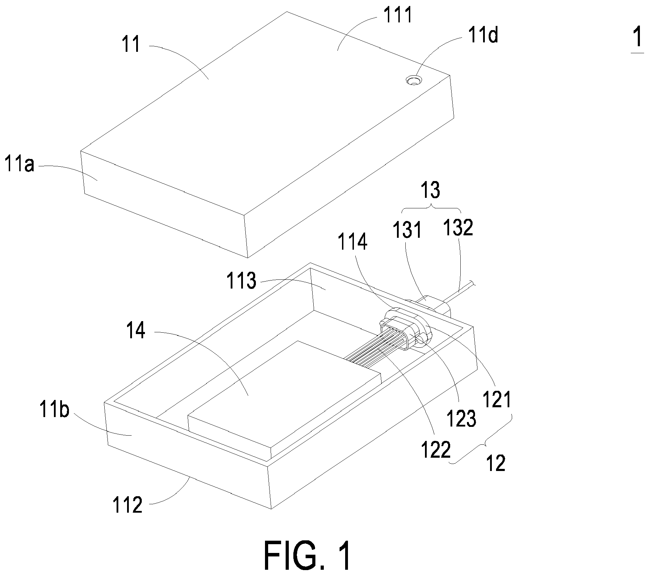

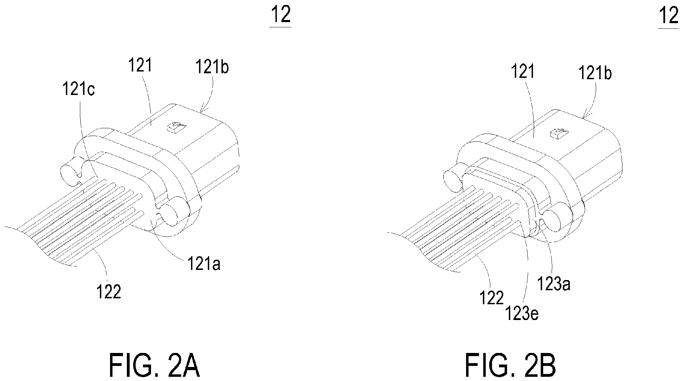

FIG. 1 is a schematic view illustrating an electric apparatus with an electric connection and protection function according to a first embodiment of the present disclosure. FIGS. 2A to 2D schematically illustrate a process of fabricating a first connector of the electric apparatus as shown in FIG. 1. The electric apparatus with an electric connection and protection function 1 (hereinafter referred to as electric apparatus 1) is electrically connected with an electronic system (not shown). The electric apparatus 1 comprises a casing 11, a first connector 12 and an electronic component 14.

The casing 11 comprises a top wall 111, a bottom wall 112, a plurality of lateral walls 113 and at least one first opening 114. The first opening 114 is located at any lateral wall 113, the top wall 111 or the bottom wall 112. Preferably but not exclusively, the first opening 114 is located at the lateral wall 113. In some embodiments, the casing 11 further comprises a ventilation valve 11d. The ventilation valve 11d allows the air in the interior of the casing 11 to flow therethrough and preventing the moisture in the environment from introducing into the interior of the casing 11. In this embodiment, the casing 11 is an assembly of a top cover 11a and a bottom cover 11b. Moreover, the casing 11 further comprises a sealing interface (not shown). Preferably but not exclusively, the sealing interface is located at the junction between the top cover 11a and the bottom cover 11b. Alternatively, the casing 11 is assembled through an installation element with another structure. The installation element is formed as the casing 11 through the sealing interface. In some embodiments, the casing 11 is a fully-sealed casing.

In this embodiment, the first connector 12 is a wall-mount connector. The first connector 12 is penetrated through the first opening 114 of the casing 11 and fixed on the casing 11. The first connector 12 comprises a first connection body 121, at least one first wire 122, a protection device 123 and a plurality of first pins (not shown). In accordance with the present disclosure, the structure of the first connector 12 is specially designed. Hereinafter, the structure of the first connector 12 and a method of fabricating the first connector 12 will be described with reference to FIGS. 2A to 2D.

Please refer to FIGS. 1 and 2A. Firstly, the main part of the first connector 12 is formed. The main part of the first connector 12 comprises the first connection body 121, the at least one first wire 122 and the plurality of first pins (not shown). The first connection body 121 has a first end 121a and a second end 121b. When the first connection body 121 is penetrated through the first opening 114 of the casing 11, the first end 121a of the first connection body 121 is disposed within the casing 11, the second end 121b of the first connection body 121 is located outside the casing 11, and a portion of the first connection body 121 is embedded within the first opening 114 of the casing 11. The first end 121a of the first connection body 121 is served as a wire-outlet end. Moreover, at least one wire-outlet hole 121c is located at the first end 121a of the first connection body 121. The plurality of first pins are disposed within the first connection body 121. Preferably, the at least one first wire 122 comprises a plurality of first wires. A first end of the first wire 122 is connected with the corresponding first pin. Moreover, the junction between the first wire 122 and the corresponding first pin is disposed within the first connection body 121. The first wire 122 is routed from the corresponding wire-outlet hole 121c at the first end 121a of the first connection body 121 (i.e., the wire-outlet end). A second end of the first wire 122 is electrically connected with the electronic component 14. In an embodiment, the electronic component 14 is disposed within the casing 11. Moreover, the electronic component 14 is connected with the second end of the first wire 122. An example of the electronic component 14 includes but is not limited to a circuit board.

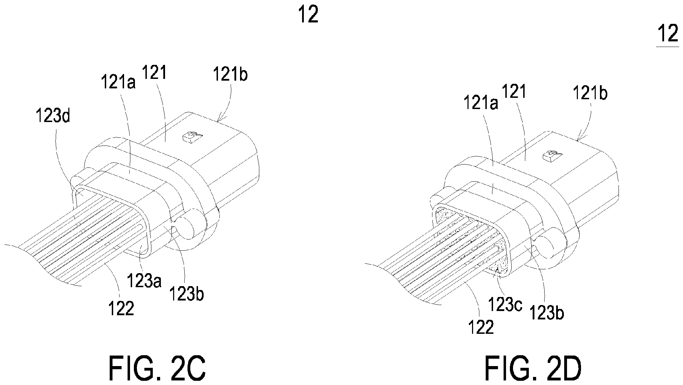

After the main part of the first connector 12 is formed, the protection device 123 is provided and coupled to the main part of the first connector 12. Please refer to FIGS. 2B, 2C and 2D. The protection device 123 is disposed on the first end 121a of the first connection body 121 (i.e., the wire-outlet end). Moreover, the wire-outlet hole 121c and a portion of the first wire 122 close to the first end 121a of the first connection body 121 are covered by the protection device 123. After the vacant space between the wire-outlet hole 121c and the first wire 122 is sealed by the protection device 123, the inside and outside of the first connector 12 is isolated from each other and the junction between the first cable 122 and the first wire 122 can be further isolated from the outside. In an embodiment, the protection device 123 comprises a protective stopper 123a, a potting wall 123b and a protective sealant 123c.

Please refer to FIG. 2B again. The protective stopper 123a is located at the first end 121a of the first connection body 121. A first side of the protective stopper 123a is arranged beside the first end 121a of the first connection body 121, so that the at least one wire-outlet hole 121c is sealed by the protective stopper 123a. The protective stopper 123a comprises at least one second opening 123e. The at least one first wire 122 is penetrated through the corresponding second opening 123e. The wire-outlet hole 121c and a portion of the first wire 122 close to the first end 121a of the first connection body 121 are covered by the protective stopper 123a. The protective stopper 123a is made of an insulating material.

Please refer to FIG. 2C again. Then, the potting wall 123b is connected with and externally protruded from the first end 121a of the first connection body 121. Consequently, the protective stopper 123a is enclosed by the potting wall 123b. In addition, a portion of the first wire 122 is enclosed by the potting wall 123b. Consequently, a vacant space 123d is formed between the potting wall 123b and the first wire 122. The vacant space 123d is located beside the protective stopper 123a. Moreover, the potting wall 123b is made of the insulating material.

Please refer to FIG. 2D again. The protective sealant 123c is filled in the vacant space 123d within the potting wall 123b and located beside a second side of the protective stopper 123a, wherein the second side is opposite to the first side. Moreover, the protective stopper 123a is made of the insulating material.

As mentioned above, the protection device 123 is disposed on the first end 121a of the first connection body 121. Due to the protection device 123, the air within the first connection body 121 of the first connector 12 is not communication with the ambient air. Moreover, because of the protection device 123, no vacant space is formed between the first connection body 121 and the first wire 122 and the junction between the first connection body 121 and the first wire 122 is completely sealed. Since the electric apparatus 1 is not influenced by the ambient moisture, the connecting condition and the operating condition of the electric apparatus 1 are more stable.

In an embodiment, as shown in FIG. 1, the electric apparatus 1 further comprises a second connector 13. The second connector 13 comprises a second connection body 131, at least one second wire 132 and at least one second pin (not shown). The at least one second pin is disposed within the second connection body 131. A first end of the second wire 132 is connected with the corresponding second pin. A second end of the second wire 132 is connected with the electronic system (not shown). The second connector 13 is connected with the electronic system to receive electric power or signals from the electronic system or transmit electric power or signals to the electronic system. The second connector 13 is coupled with the first connector 12. That is, the second connector 13 is coupled with the second end 121b of the first connection body 121 of the first connector 12. Consequently, the at least first pin of the first connector 12 and the corresponding second pin of the second connector 13 are electrically connected with each other. In such way, electric power or signal can be transferred between the electronic system and the electric apparatus 1 through the first connector 12 and the second connector 13. Preferably but not exclusively, the first connector 12 and the second connector 13 are power connectors (e.g., high voltage power connectors) or signal connectors. In case that the first connector 12 is a female connector, the second connector 13 is a male connector. In case that the first connector 12 is a male connector, the second connector 13 is a female connector.

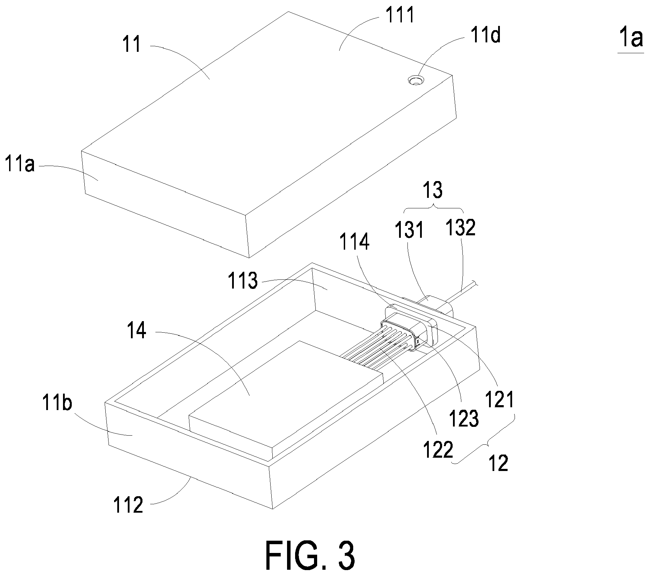

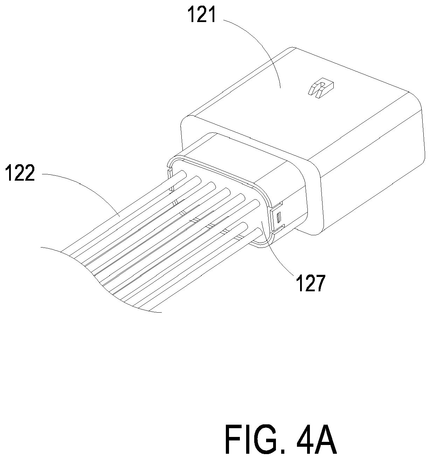

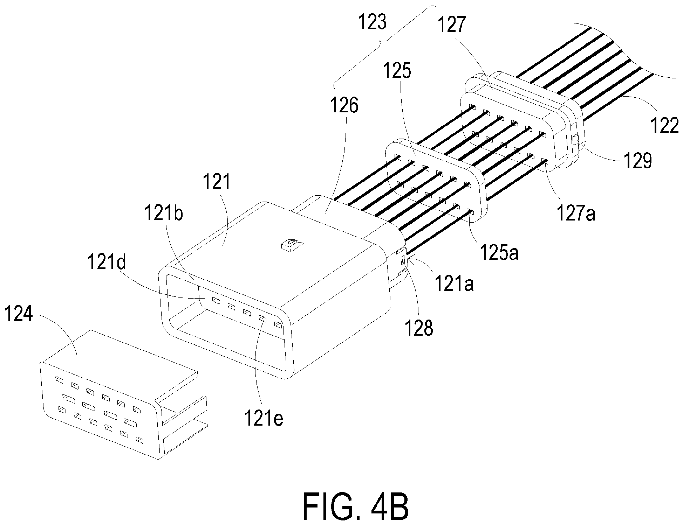

FIG. 3 is a schematic view illustrating an electric apparatus with an electric connection and protection function according to a second embodiment of the present disclosure. FIG. 4A is a schematic perspective view illustrating the first connector of the electric apparatus as shown in FIG. 3. FIG. 4B is a schematic exploded view illustrating the first connector as shown in FIG. 4A and taken along another viewpoint. The electric apparatus 1a comprises a casing 11, a first connector 12, a second connector 13 and an electronic component 14. The structures of the casing 11, the second connector 13 and the electronic component 14 of the electric apparatus 1a are similar to those of the electric apparatus 1 of the first embodiment, and are not redundantly described herein. Component parts and elements corresponding to those of the first embodiment are designated by identical numeral references, and detailed descriptions thereof are omitted. In comparison with the first embodiment, the first connection body 121 and the protection device of the first connector 12 are distinguished.

In this embodiment, the first connection body 121 of the first connector 12 comprises a pin fixture 124 and an inner partition structure 121d. The pin fixture 124 is accommodated within the second end 121b of the first connection body 121 in order to support the at least one first pin. The inner partition structure 121d is disposed within the first connection body 121. The inner partition structure 121d comprises a plurality of through holes 121e. The first pins on the pin fixture 124 are penetrated through the corresponding through holes 121e and extended to the first end 121a of the first connection body 121. Consequently, the junction between the at least one first wire 122 and the corresponding first pin is disposed within the first connection body 121.

In this embodiment, the protection device 123 comprises a protective stopper 125, a potting wall 126 and a protective cap 127.

The protective stopper 125 comprises at least one third opening 125a. The at least one first wire 122 is penetrated through the corresponding third opening 125a. Moreover, the protective stopper 125 is fixed in the first end 121a of the first connection body 121. The protective stopper 125 is made of an insulating material.

The potting wall 126 is connected with and externally protruded from the first end 121a of the first connection body 121. Consequently, the first end 121a of the first connection body 121 is enclosed by the potting wall 126. Preferably, the potting wall 126 is integrally formed with the first end 121a of the first connection body 121. Moreover, the potting wall 126 is made of the insulating material.

The protective cap 127 comprises at least one fourth opening 127a. The at least one first wire 122 is penetrated through the corresponding fourth opening 127a. Moreover, the protective cap 127 is coupled with the potting wall 126. Consequently, the protective stopper 125 is tightly fixed within the potting wall 126. The protective cap 127 is made of an insulating material.

In an embodiment, the first connection body 121 further comprises a first engaging element 128, and the protective cap 127 comprises a second engaging element 129. The first engaging element 128 and the second engaging element 129 are engaged with each other. Consequently, the protective cap 127 is fixed on the first connection body 121.

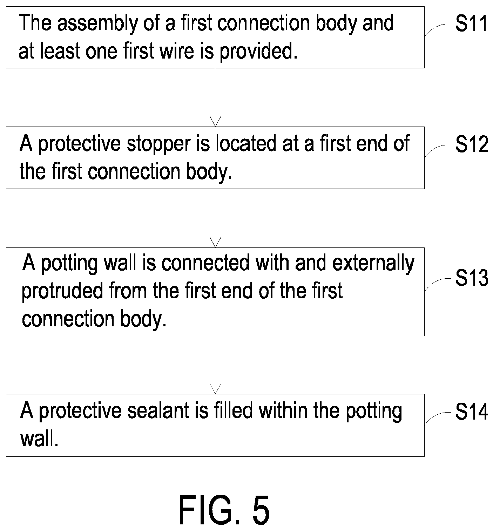

FIG. 5 is a flowchart illustrating a method of fabricating the first connector of the electric apparatus as shown in FIG. 1. Please refer to FIGS. 2A to 2D and FIG. 5. Firstly, in a step S11, the assembly of the first connection body 121 and the at least one first wire 122 is provided. The connecting relationship between the first connection body 121 and the at least one first wire 122 is identical to that of FIG. 2A, and is not redundantly described herein. In a step S12, a protective stopper 123a is provided. The protective stopper 123a is located at the first end 121a of the first connection body 121. The wire-outlet hole 121c and a portion of the first wire 122 close to the first end 121a of the first connection body 121 are covered by the protective stopper 123a. In a step S13, a potting wall 123b is connected with and externally protruded from the first end 121a of the first connection body 121. Consequently, the protective stopper 123a is enclosed by the potting wall 123b. In a step S14, a protective sealant 123c is filled within the potting wall 123b. Meanwhile, the first connector 121 is fabricated.

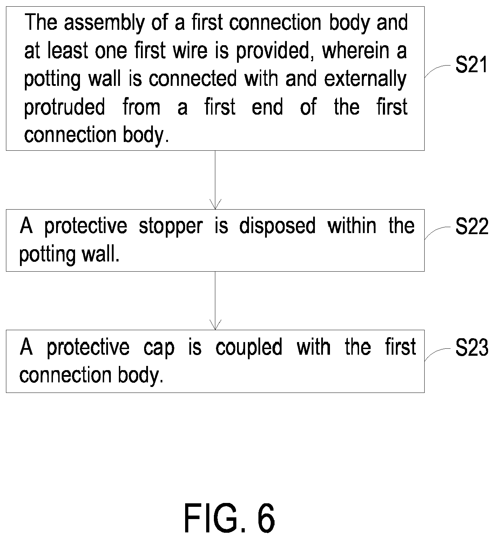

FIG. 6 is a flowchart illustrating a method of fabricating the first connector of the electric apparatus as shown in FIG. 3 according to an embodiment of the present disclosure. Please refer to FIGS. 4A, 4B and 6. Firstly, in a step S21, the assembly of the first connection body 121 and the at least one first wire 122 is provided. The connecting relationship between the first connection body 121 and the at least one first wire 122 is identical to that mentioned above, and is not redundantly described herein. Moreover, a potting wall 126 is connected with and externally protruded from the first end 121a of the first connection body 121. In a step S22, a protective stopper 125 is disposed within the potting wall 126 and the at least one first wire 122 is penetrated through the corresponding third opening 125a of the protective stopper 125. The wire-outlet hole 121c and a portion of the first wire 122 close to the first end 121a of the first connection body 121 are covered by the protective stopper 125. In a step S23, a protective cap 127 is coupled with the first connection body 121. Consequently, the protective stopper 125 is tightly fixed within the potting wall 126. Meanwhile, the first connector 121 is fabricated.

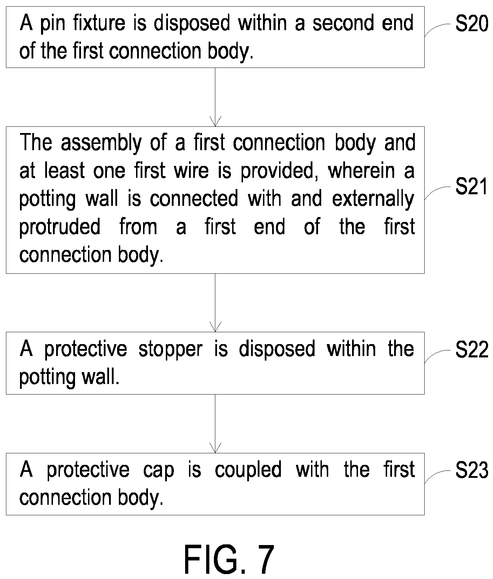

FIG. 7 is a flowchart illustrating a method of fabricating the first connector of the electric apparatus as shown in FIG. 3 according to another embodiment of the present disclosure. In comparison with the embodiment of FIG. 6, the fabricating method further comprises a step S20 before the step S21. In the step S20, a pin fixture 124 is disposed within the second end 121b of the first connection body 121. In some embodiments, in the step S22, the protective stopper 125 is attached to one end of the pin fixture 124.

From the above descriptions, the present disclosure provides an electric apparatus with an electric connection and protection function and a connector of the electric apparatus. The electric apparatus comprises a wall-mount connector. The vacant spaces between the wire-outlet holes of the connector and the wires are sealed. Since the inside and outside of the connector are isolated, the waterproof, temperature-resistant and heat-insulation functions can be achieved. Since the junction between the internal pins of the connector and the wires is not suffered from a rusting problem or a short-circuited problem caused by the ambient moisture, the connecting condition and the operating condition of the electric apparatus are more stable. In such way, the electric apparatus can be applied to the specific environment such as an outdoor low-temperature environment or a high humidity environment. The present disclosure provides a method of fabricating the connector in the cost-effective, simplified and mass-production manners.

## Claims

1. A connector (12), **characterized in that** the connector comprises:
a connection body (121) having a first end (121a) and a second end (121b);
at least one pin disposed within the connection body (121);
at least one wire (122), wherein a first end of the wire (122) is connected with the corresponding pin and routed from the first end (121a) of the connection body (121); and
a protection device (123) disposed on the first end (121a) of the connection body (121), wherein the first end (121a) of the connection body (121) and a portion of the at least one wire (122) are sealed and covered by the protection device (123);
wherein the connection body (121) comprises at least one wire-outlet hole (121c) located at the first end (121a) thereof, the at least one wire-outlet hole (121c) and a portion of the at least one wire (122) close to the first end (121a) of the connection body (121) are covered and sealed by the protection device (123), so that a vacant space formed between the at least one wire-outlet hole (121c) and the corresponding wire (122) is sealed;
wherein the protection device (123) comprises:
a protective stopper (123a, 125) located at the first end (121a) of the connection body (121), wherein a first side of the protective stopper (123a, 125) is arranged beside the first end (121a) of the first connection body (121), so that the at least one wire-outlet hole (121c) is sealed by the protective stopper (123a, 125), wherein the protective stopper (123a, 125) comprises an opening (123e, 125a), and the at least one wire (122) is penetrated through the corresponding opening (123e, 125a) of the protective stopper (123a, 125); and
a potting wall (123b, 126) connected with and protruded externally from the first end (121a) of the connection body (121) to enclose the first end (121a) of the connection body (121), wherein the protective stopper (123a, 125) is disposed within the potting wall (123b, 126).

2. The connector (12) according to claim 1, wherein the connector (12) is a wall-mount connector, and the connector (12) is partially embedded in an opening (114) of a casing (11), wherein the first end (121a) of the connection body (121) is disposed within the casing (11), the second end (121b) of the connection body (121) is located outside the casing (11), and a portion of the connection body (121) is embedded within the opening (114) of the casing (11).

3. The connector (12) according to claim 1, wherein the protection device (123) comprises:
a protective sealant (123c) filled within the potting wall (123b), and arranged beside a second side of the protective stopper (123a).

4. The connector (12) according to claim 1, wherein the protection device (123) comprises:
a protective cap (127) coupled with the connection body (121), wherein at least a portion of the protective cap (127) is accommodated within the potting wall (126), so that the protective stopper (125) is fixed within the potting wall (126).

5. The connector (12) according to claim 4, wherein the connection body (121) further comprises a first engaging element (128), and the protective cap (127) comprises a second engaging element (129), wherein the first engaging element (127) and the second engaging element (129) are engaged with each other, so that the protective cap (127) is fixed on the connection body (121).

6. The connector (12) according to claim 1, wherein a junction between the wire (122) and the corresponding pin is disposed within the connection body (121), and the at least one wire (122) is routed from the corresponding wire-outlet hole (121c).
